# EUROPÄISCHE PATENTANMELDUNG

(11) **EP 4 215 641 A1**
(43) Veröffentlichungstag der Anmeldung: **26.07.2023**
(21) Anmeldenummer: 22209087.0
(22) Anmeldetag: 23.11.2022
(51) Int. Cl.: C23C 16/26, C23C 16/34, C23C 16/44, C23C 16/54, B01J 8/16

(54) **VERFAHREN UND VORRICHTUNG ZUM BESCHICHTEN VON KURZFASERN**

(30) Priorität: 19.01.2022 DE 102022101162
(71) Anmelder: ArianeGroup GmbH, 82024 Taufkirchen (DE)
(72) Erfinder: Hofbauer, Peter Josef, 82024 Taufkirchen (DE); Endres, Alexander, 83075 Bad Feilnbach (DE)
(74) Vertreter: Schornack, Oliver

(57) **Zusammenfassung**

Es wird ein Verfahren zum Beschichten von Kurzfasern beschrieben, das ein Zuführen (315) eines Reaktionsgases in einen Reaktor (1), ein Einbringen (310) von Kurzfasern in den Reaktor (1), ein Versetzen (320) des Reaktors (1) in eine Schwingung zwischen 1 Hz und 80 Hz, bevorzugt zwischen 10 Hz und 40 Hz, und ein Heizen (340) des Reaktors (1) umfasst, wobei ein in dem Reaktionsgas enthaltener Stoff aus dem Reaktionsgas abgeschieden wird und sich auf den Kurzfasern ablagert. Ferner wird eine Vorrichtung mit einem Reaktor (1), einer Fördereinrichtung (10), einem erregenden Antrieb (6), und einem Heizer (3) beschrieben, die verwendet werden kann, um das Verfahren auszuführen.

## Beschreibung

Die Erfindung betrifft ein Verfahren und eine Vorrichtung zum Beschichten von Kurzfasern. Insbesondere betrifft die Erfindung ein Verfahren und eine Vorrichtung zum Beschichten von Kurzfasern, wobei die Kurzfasern durch einen in Schwingung versetzten und beheizten Reaktor geführt werden und aus einem in dem Reaktor befindlichen Gas ein Stoff ausgeschieden wird, der sich auf den Kurzfasern ablagert.

Im Bereich der keramischen Faserverbundwerkstoffe werden Fasern zum Schutz vor Umwelt- und Fertigungseinflüssen, aber auch zur Beeinflussung des Bruchverhaltens, beschichtet. Beispielsweise können nicht-oxidische Fasern durch Oxidation oder bei einer, ein Silizierverfahren umfassenden, Herstellung durch das schmelzflüssige Silizium angegriffen werden. Als Faserschutz können daher Schichten aus Bornitrid (BN) oder Kohlenstoff dienen.

Zu den bisherigen Verfahren zur Faserbeschichtung zählen nasschemische Verfahren, wie zum Beispiel eine Tauchbeschichtung, sowie trockene Verfahren, wie zum Beispiel die Gasphasenabscheidung (engl. Chemical Vapour Deposition, CVD). Jedoch können bei den nasschemischen Verfahren inhomogene Schichtdicken entstehen. Bei den trockenen Verfahren kommt es mit kürzer werdenden Faserlängen vermehrt zur Agglomeratbildung.

Vor diesem Hintergrund liegt der vorliegenden Erfindung die Aufgabe zugrunde, ein Verfahren und eine Vorrichtung zum Beschichten von Kurzfasern bereitzustellen, die eine einheitliche Beschichtung auch größerer Fasermengen ermöglichen.

Diese Aufgabe wird durch ein Verfahren mit den Merkmalen des Anspruchs 1 sowie eine Vorrichtung mit den Merkmalen des Anspruchs 7 gelöst.

Gemäß einem ersten Aspekt zum besseren Verständnis der vorliegenden Offenbarung umfasst ein Verfahren zum Beschichten von Kurzfasern ein Zuführen eines Reaktionsgases in einen Reaktor, ein Einbringen von Kurzfasern in den Reaktor, ein Versetzen des Reaktors in eine Schwingung zwischen 1 Hz und 80 Hz, bevorzugt zwischen 10 Hz und 40 Hz, und ein Heizen des Reaktors, wobei ein in dem Reaktionsgas enthaltener Stoff aus dem Reaktionsgas abgeschieden wird und sich auf den Kurzfasern ablagert.

Die Kurzfasern können somit in dem Reaktor mittels chemischer Gasphasenabscheidung beschichtet werden. Insbesondere werden die Kurzfasern aufgrund der Schwingung des Reaktors durch eine Reaktionszone des Reaktors gefördert. Zum Beispiel werden die Kurzfasern im Reaktor aufgrund der Schwingung in den Gasstrom des Reaktionsgases geworfen, wo sie dispergieren und beschichtet werden.

Diese Form der Förderung der Kurzfasern durch den Reaktor ermöglicht eine gleichmäßige Beschichtung der Kurzfasern, während die Agglomeratbildung (im Vergleich zu anderen Förderverfahren) signifikant reduziert wird. Insbesondere aufgrund der Schwingungen mit einer Frequenz im genannten Bereich werden die Kurzfasern in dem Reaktor zerstäubt und können während ihrer Flugphase von dem Reaktionsgas umströmt werden. Dies führt zu einer einheitlichen und umseitigen Beschichtung der Kurzfasern in der Reaktionszone.

Durch einen kontinuierlich zugeführten Gasstrom mit entsprechender Strömungsgeschwindigkeit durch den Reaktor können die Kurzfasern durch die Reaktionszone und aus dem Reaktor heraus befördert werden. Dadurch können die Fasern in der Reaktionszone zerstäubt werden, wo sie von dem Strom des Reaktionsgases zur Beschichtung umgeben werden und gleichzeitig weitertransportiert werden.

In der vorliegenden Offenbarung wird unter "Kurzfasern" eine Faser verstanden, die eine (mittlere) Faserlänge kleiner gleich 3 mm aufweist. Es kann sich dabei auch um ein Fasergemisch mit unterschiedlichen Faserlängen handeln, wobei die Faserlängen nicht größer als 3 mm oder wobei die mittleren Faserlänge nicht größer als 3 mm ist. In einer speziellen Ausgestaltung beträgt die (mittlere) Faserlänge der Kurzfasern weniger oder gleich 2 mm, und in einer weiteren speziellen Ausgestaltung ist die (mittlere) Faserlänge kleiner gleich 1 mm. Zum Beispiel kann eine Kurzfaser eine Länge von 5 bis 1000 µm, bevorzugt zwischen 10 bis 500 µm aufweisen. All diese Kurzfasern tendieren im Vergleich zu längeren Fasern dazu, Agglomerate zu bilden oder anderweitig aneinander zu haften und Ansammlungen zu bilden. Ferner können die Fasern Durchmesser von 2 bis 20 µm, bevorzugt von 5 bis 15 µm aufweisen.

Das Verfahren kann ferner ein Kippen des Reaktors umfassen, wodurch eine schräge Wurfbahn der Fasern im Inneren des Reaktors erzielt wird. Dies begünstigt eine Vorwärtsbewegung der Fasern, d. h. von einem Einlass des Reaktors zu einem Auslass des Reaktors. Dies erlaubt ferner einen sehr geringen oder gar keinen Strom von Reaktionsgas durch den Reaktor, wodurch ein beruhigtes Beschichten der Kurzfasern möglich ist.

Die Fasern befinden sich zu einem Großteil ihrer Verweilzeit in dem Reaktor in der Flugphase und sind dispergiert. Dies erhöht die Zugänglichkeit der Fasern für das Reaktionsgas im Vergleich zu einer Schüttung deutlich, was einen insgesamt höheren Durchsatz an Fasern durch den Reaktor bei weiterhin einheitlicher Beschichtung der Fasern ermöglicht.

In einer Implementierungsvariante kann das Versetzen des Reaktors in eine Schwingung ein Bewegen des Reaktors mit einer Amplitude zwischen 0,5 mm und 10 mm, bevorzugt zwischen 1 mm und 5 mm, umfassen. Diese Amplitude in Kombination mit den Faserlängen der Kurzfasern ermöglicht eine gute Förderung der Kurzfasern durch den Reaktor.

Alternativ oder zusätzlich kann eine Fördergeschwindigkeit der Kurzfasern in dem Reaktor durch die Schwingung des Reaktors, insbesondere der Frequenz und/oder Amplitude, durch die Verkippung des Reaktors und/oder durch den Gasstrom eingestellt werden.

Bei konventionellen Reaktoren, wie zum Beispiel einem Drehrohrofen, fallen die Fasern aufgrund einer Rotation des Reaktors durch das Reaktionsgas. Dies bedingt jedoch eine ungleichmäßige Schüttung der Fasern und eine ungleichmäßige Verweilzeit der Fasern in dem Reaktionsgas. Dadurch können Fasern nicht vollständig vom Reaktionsgas umströmt und folglich nicht vollständig beschichtet werden. In der vorliegenden Offenbarung kann auf eine Rotation verzichtet werden, wodurch die oben beschriebene einheitliche Beschichtung auch größerer Fasermengen ermöglicht wird.

In einer weiteren Implementierungsvariante kann das Verfahren ein Sammeln der beschichteten Kurzfasern aus dem Reaktor in einem Auffangbehälter umfassen. Der Auffangbehälter kann beispielsweise an einem Auslass des Reaktors angeordnet sein, wobei die beschichteten Kurzfasern aufgrund ihrer Förderung durch den Reaktor am Auslass aus dem Reaktor herausfallen und durch den Auffangbehälter aufgefangen werden können. Der Auslass kann beispielsweise einen flexiblen Schlauch umfassen oder durch diesen gebildet sein. Dies ermöglicht eine kontinuierliche oder semi-kontinuierliche Beschichtung von Kurzfasern, wodurch auch größere Mengen von beschichteten Kurzfasern in einfacher und kostengünstiger Weise hergestellt werden können.

In noch einer weiteren Implementierungsvariante kann das Einbringen von Kurzfasern in den Reaktor ein Anschließen eines mit unbeschichteten Kurzfasern gefüllten Behälters an einen Einlass des Reaktors umfassen. Das Anschließen kann beispielsweise mittels eines flexiblen Schlauchs erfolgen. Ferner kann das Einbringen von Kurzfasern in den Reaktor ein Fördern der Kurzfasern durch eine Förderschnecke umfassen. Die Förderschnecke kann beispielsweise in dem mit unbeschichteten Kurzfasern gefüllten Behälter angeordnet sein, oder ein Auslass des Behälters kann an eine Förderschnecke angeschlossen werden.

in einer weiteren Implementierungsvariante kann das Einbringen von Kurzfasern in den Reaktor und/oder das Sammeln der beschichteten Kurzfasern aus dem Reaktor ein Öffnen und Schließen eines Einlasses bzw. Auslasses des Reaktors umfassen. zum Beispiel kann mindestens ein Absperrventil an oder vor dem Einlass bzw. an oder nach dem Auslass des Reaktors vorgesehen sein, durch das die entsprechende Zufuhr von Kurzfasern bzw. Entnehmen von Kurzfasern (kurzzeitig) gesperrt werden kann. Dadurch lässt sich während des Betriebs des Reaktors ein Behälter mit unbeschichteten Kurzfasern bzw. ein Behälter mit beschichteten Kurzfasern wechseln.

In einer anderen Implementierungsvariante kann das Heizen ein Heizen des Reaktors auf eine Temperatur zwischen 700 °C und 1600 °C, bevorzugt auf eine Temperatur zwischen 900 °C und 1400 °C, umfassen. Die Temperatur des Reaktors begünstigt die Zersetzungsreaktionen die zum Abscheiden des gewünschten Stoffes aus dem Reaktionsgas (oder Trägergas) führen.

In einer weiteren Implementierungsvariante kann das Kippen ein Kippen des Reaktors auf eine Neigung von 0° bis 10°, bevorzugt auf eine Neigung von 0° und 5°, gegenüber einer Horizontalen umfassen. Je nach Neigung, Amplitude, Frequenz und/oder Geschwindigkeit des Reaktionsgases durch den Reaktor kann die Durchsatzgeschwindigkeit der Kurzfasern durch den Reaktor angepasst werden. Dieses Anpassen der Geschwindigkeit der Kurzfasern durch den Reaktor ermöglicht neben der Zusammensetzung des Reaktionsgases ein Einstellen einer Schichtdicke der Beschichtung der Kurzfasern, die in dem Reaktor erzielt werden kann, aufgrund der Verweilzeit der Kurzfasern in dem Reaktionsgas (in der Reaktionszone).

In noch einer weiteren Implementierungsvariante können die Kurzfasern Kohlenstofffasern und/oder Siliziumcarbidfasern sein. Diese Fasern können nach dem Beschichten in keramischen Verbundwerkstoffen eingesetzt werden, insbesondere in Werkstoffen für den Einsatz in Hochtemperaturbereichen und/oder in oxidischer Atmosphäre. Lediglich beispielhaft können solche keramischen Verbundwerkstoffe an Raketentriebwerken, insbesondere einer Brennkammer und/oder Schubdüse des Raketentriebwerks, eingesetzt werden. Ebenso können die beschichteten Fasern bei der Herstellung von kohlenstofffaserverstärktem Siliziumcarbid (Cf/SiC) verwendet werden

Alternativ oder zusätzlich kann der abzuscheidende Stoff aus dem Reaktionsgas Kohlenstoff und/oder Bornitrid sein. Dies ermöglicht, dass die Kurzfasern mit pyrolytischem Kohlenstoff (pyC) und/oder pyrolytischem Bornitrid (pBN) beschichtet werden. Diese Beschichtungen können eine Orientierung aufweisen. Diese Ausrichtung führt zu anisotropen Eigenschaften der Schicht auf der Faser, insbesondere wenn diese in eine keramische Matrix eingebettet wird. Die anisotropen Eigenschaften sind für bestimmte Versagensmechanismen des keramischen Faserverbundwerkstoffes notwendig.

Gemäß einem zweiten Aspekt zum besseren Verständnis der vorliegenden Offenbarung umfasst eine Vorrichtung zum Beschichten von Kurzfasern einen Reaktor, eine Fördereinrichtung, die dazu eingerichtet ist, Kurzfasern in den Reaktor einzubringen, ein Mittel zum Zuführen eines Reaktionsgases in den Reaktor, einen erregenden Antrieb, der dazu eingerichtet ist, den Reaktor in eine Schwingung zwischen 1 Hz und 80 Hz, bevorzugt zwischen 10 Hz und 40 Hz, zu versetzen, und einen Heizer, der dazu eingerichtet ist, den Reaktor zu heizen, wobei ein in dem Reaktionsgas enthaltener Stoff aus dem Reaktionsgas abgeschieden wird und sich auf den Kurzfasern ablagert.

Der Reaktor kann beispielsweise aus einem Rohr bestehen oder ein Rohr umfassen. Dieser/Dieses kann beispielsweise aus Aluminiumoxid (Al2O3), Silizium-Siliziumcarbid (SiSiC), Siliziumnitrit (Si3N4) und ähnlichen hitzebeständigen Materialien hergestellt sein. Ferner kann der Reaktor als Heißwandreaktor fungieren, d. h. eine Außenseite des Reaktors wird durch den Heizer erhitzt, wodurch auch dessen Innenwand aufheizt und die Wärme an das in dem Reaktor befindliche Reaktionsgas und die Kurzfasern abgibt. Lediglich beispielhaft kann der Reaktor einen Innendurchmesser kleiner 100 mm, vorzugsweise zwischen 30 und 60 mm, aufweisen.

Das Mittel zum Einführen des Reaktionsgases in den Reaktor kann in die Fördereinrichtung integriert sein oder durch eine getrennte Gaszufuhr implementiert sein.

In einer Implementierungsvariante kann die Vorrichtung ferner eine Kippvorrichtung umfassen, die dazu eingerichtet ist, den Reaktor zu kippen. Je nach Neigung (gegenüber der Horizontalen) kann eine Wurfbahn der Fasern innerhalb des Reaktors eingestellt werden, wodurch die Fördergeschwindigkeit und Fördermenge der Kurzfasern durch den Reaktor einstellbar ist.

In einer anderen Implementierungsvariante kann die Vorrichtung ferner einen Vorratsbehälter umfassen, in dem unbeschichtete Kurzfasern für die Förderung durch die Fördereinrichtung gelagert werden. Dies ermöglicht eine kontinuierliche Zufuhr von Kurzfasern in den Reaktor, wodurch eine große Menge von Kurzfasern in einem Prozessschritt beschichtet werden kann. Optional kann die Fördereinrichtung in dem Vorratsbehälter angeordnet sein oder an einem Auslass des Vorratsbehälters vorgesehen sein.

Alternativ oder zusätzlich kann die Vorrichtung ferner einen Auffangbehälter umfassen, der dazu eingerichtet ist, beschichtete Fasern aus dem Reaktor zu sammeln. Der Auffangbehälter kann beispielsweise an einem Auslass des Reaktors angeordnet sein, sodass Kurzfasern aus dem Auslass des Reaktors herausfallen und sich in dem Auffangbehälter sammeln. Selbstverständlich kann auch ein (flexibler) Schlauch, ein Rohr, eine Rutsche oder ähnliches Element zwischen dem Auslass des Reaktors und dem Auffangbehälter vorgesehen sein, in dem bzw. auf der die Kurzfasern in den Auffangbehälter rutschen. Ebenso kann eine weitere Fördereinrichtung vorgesehen sein, um die beschichteten Kurzfasern von dem Auslass des Reaktors zu dem Auffangbehälter zu fördern.

In noch einer anderen Implementierungsvariante kann die Fördereinrichtung eine Förderschnecke, ein Förderband oder ähnliches Transportelement umfassen. Alternativ oder zusätzlich kann die Fördereinrichtung die Kurzfasern auch in einen Strom des Reaktionsgases vor dem Einleiten (Zuführen) in den Reaktor einstreuen oder rieseln, sodass der Reaktionsgasstrom die Kurzfasern fördert und letztendlich in den Reaktor einbringt.

Ferner kann die Fördereinrichtung optional einen (flexiblen) Schlauch, ein Rohr, eine Rutsche oder ähnliches Element umfassen, das die Kurzfasern in den Reaktor leitet. Beispielsweise kann dieses Element zwischen einer Förderschnecke und einem Einlass des Reaktors angeordnet sein.

In einer Implementierungsvariante kann ein Inneres des Reaktors gegenüber seiner Umgebung abgedichtet sein. Dadurch wird verhindert, dass das Reaktionsgas aus dem Reaktor entweicht. Mit dem Sauerstoff der Umgebung könnten sich andernfalls exklusive Atmosphären bilden. Ferner kann das Reaktionsgas nach Verlassen des Reaktors gegebenenfalls aufbereitet und wiederverwendet werden. Hier bietet die beschriebene Vorrichtung Vorteile gegenüber herkömmlichen Reaktoren. Da bei der vorliegenden Vorrichtung keine drehenden Elemente, insbesondere dem Reaktor, vorhanden sind, müssen keine drehenden (gleitenden) Dichtungen zur Abdichtung des Reaktorinneren vorgesehen werden.

In einer weiteren Implementierungsvariante kann der erregende Antrieb einen Kurbelwellenantrieb, einen Piezoaktuator, eine oder mehrere Federn und/oder einen Nockenwellenantrieb umfassen. Beispielsweise kann der Reaktor mit dem Kurbelwellenantrieb gekoppelt sein, sodass bei einer Rotation der Kurbelwelle des Kurbelwellenantriebs der Reaktor in Schwingung versetzt wird. Dabei kann der Hub der Kurbelwelle die Amplitude der Schwingung bestimmen. Gleiches gilt für einen Nockenwellenantrieb. Im Fall eines Piezoaktuators kann durch Anlegen einer elektrischen Spannung an das Piezoelement des Aktuators eine Längenveränderung des Aktuators bewirkt werden, die mit dem Reaktor gekoppelt werden kann, um die Schwingung zu erzeugen. Eine oder mehrere Federn (zum Beispiel Zugfedern, Druckfedern und/oder Plattfedern) können mit jedem der hier beschriebenen Antriebe kombiniert werden, wodurch die Schwingungsfrequenz und/oder die Amplitude der Schwingung sowie eine Dämpfung des Reaktors einstellbar ist.

In einer anderen Implementierungsvariante kann die Vorrichtung ferner einen Ofen umfassen, der den Heizer und zumindest Teile des Reaktors umgibt und thermisch isoliert. Beispielsweise kann der Ofen mindestens eine Öffnung umfassen, durch die der Reaktor in den Ofen ragt. Im Inneren des Ofens kann der Heizer angeordnet sein, wodurch dessen abgegebene Wärme im Inneren des Ofens auf die Außenseite des dort befindlichen Reaktors wirkt.

Lediglich als Beispiel kann der Heizer Wärme durch einen Verbrennungsvorgang (beispielsweise mithilfe von Gas), durch Strom (zum Beispiel mithilfe von Induktion oder Widerstandsheizer) und/oder durch Licht (beispielsweise mithilfe eines Lasers oder Blitzlichts) erzeugen.

Der Ofen kann ferner zwei Öffnungen umfassen, die im Wesentlichen an gegenüberliegenden Seiten des Ofens angeordnet sind. Der Reaktor kann somit durch den Ofen durchgeführt sein, d. h. jedes Ende des Reaktors schaut auf einer gegenüberliegenden Seite des Ofens aus der jeweiligen Öffnung heraus. Die Reaktionszone des Reaktors befindet sich somit innerhalb des Ofens, d. h. innerhalb der beiden Öffnungen des Ofens.

In einer Implementierungsvariante kann der Reaktor an beiden Enden, die jeweils aus einer der beiden Öffnungen des Ofens aus dem Ofen (aus der Heizzone) herausragen, synchron zu der Schwingung angeregt werden. Dadurch kann ein optimales Schwingverhalten des Reaktors erzielt werden.

Beispielsweise kann die mindestens eine Öffnung in dem Ofen größer sein als die äußeren Dimensionen des Reaktors an dieser Stelle. Dies ermöglicht eine Bewegung des Reaktors innerhalb des Ofens, insbesondere eine Bewegung aufgrund der Schwingung, in die der Reaktor versetzt wird. Dadurch kann der erregende Antrieb außerhalb des Ofens angeordnet werden, und muss nicht für die hohen Temperaturen in dem Ofen ausgelegt werden.

In einer weiteren Implementierungsvariante kann die Kippvorrichtung den Reaktor in einer einstellbaren Neigung lagern. Durch die Neigung kann in Kombination mit der Schwingung des Reaktors eine Flugbahn der Kurzfasern im Inneren des Reaktors eingestellt werden, beispielsweise so, dass die Kurzfasern von einem Einlass des Reaktors zu einem Auslass des Reaktors transportiert werden.

Beispielsweise kann die Kippvorrichtung mit dem erregenden Antrieb gekoppelt sein oder zumindest einen Abschnitt des erregenden Antriebs bilden und so die Schwingung des erregenden Antriebs auf den Reaktor übertragen. Die Kopplung zwischen Kippvorrichtung und erregendem Antrieb kann über ein Gestänge, Seil, Auflager, Schraubverbindung, Bolzenverbindung, Manschette, etc. erfolgen. Die Kopplung kann ferner eine Führung aufweisen, entlang der der Reaktor bewegt wird, wenn er in Schwingung versetzt wird.

In noch einer weiteren Implementierungsvariante kann die Vorrichtung ferner ein Gehäuse umfassen, das den Reaktor und/ oder den Heizer und/oder den erregenden Antrieb und/oder die Kippvorrichtung umgibt. Das Gehäuse kann insbesondere einen Schutz der darin angeordneten Komponenten der Vorrichtung dienen.

In einer anderen Implementierungsvariante kann die Vorrichtung ferner ein Einlassventil umfassen, das dazu eingerichtet ist, eine Zufuhr von Kurzfasern vor einem Einlass des Reaktors (beispielsweise eine Zufuhrleitung) zu verschließen. Alternativ oder zusätzlich kann die Vorrichtung ferner ein Auslassventil umfassen, das dazu eingerichtet ist, einen Auslass des Reaktors oder eine daran anschließende Leitung zu verschließen.

Lediglich beispielhaft kann das Einlassventil an einer Verbindung zwischen dem Vorratsbehälter und dem Einlass des Reaktors angeordnet sein. Ebenso kann das Auslassventil an einer Verbindung zwischen dem Auslass des Reaktors und dem Auffangbehälter vorgesehen sein. Durch Schließen des/der Ventils/Ventile kann der Vorratsbehälter und/oder Auffangbehälter im laufenden Betrieb ausgetauscht werden. Dadurch kann eine kontinuierliche (oder semi-kontinuierliche) Herstellung von beschichteten Kurzfasern erfolgen.

Die oben beschriebenen Aspekte und Implementierungsvarianten können selbstverständlich kombiniert werden, ohne dass dies explizit beschrieben ist. Jede der beschriebenen Implementierungsvarianten ist somit optional zu jeder Implementierungsvariante oder bereits Kombinationen davon zu sehen. Die vorliegende Offenbarung ist somit nicht auf die einzelnen Ausgestaltungen und Varianten in der beschriebenen Reihenfolge oder einer bestimmten Kombination der Aspekte und Implementierungsvarianten beschränkt.

Bevorzugte Ausführungsformen der Erfindung werden nun anhand der beigefügten schematischen Zeichnungen näher erläutert, wobei
- Figur 1: schematisch eine Schnittansicht einer Vorrichtung zum Beschichten von Kurzfasern zeigt; und
- Figur 2: schematisch ein Ablaufdiagramm eines Verfahrens zur Beschichtung von Kurzfasern zeigt.

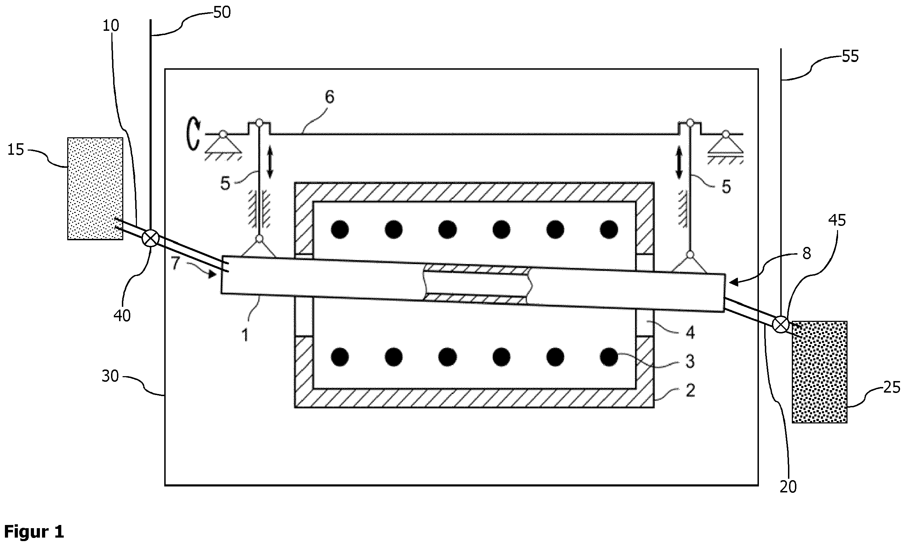

Figur 1 zeigt schematisch eine Vorrichtung zum Beschichten von Kurzfasern, die beispielsweise in einem Vorratsbehälter 15 der Vorrichtung bereitgestellt werden. Beispielsweise können in dem Vorratsbehälter 15 Kurzfasern ohne Beschichtung oder mit Beschichtung (Mehrfachbeschichtung oder Schichtsysteme mit unterschiedlichen Stoffen) oder zumindest lediglich mit einer Grundierung vorgesehen sein.

Die Vorrichtung weist eine Fördereinrichtung 10 auf, die dazu eingerichtet ist, Kurzfasern in einen Reaktor 1 einzubringen. Die Fördereinrichtung 10 kann dabei einen Schlauch, eine Rutsche, ein Rohr oder ähnliches passives Element umfassen. Ein (flexibler) Schlauch dient ferner einer Schwingungsentkopplung des Reaktors von anderen Komponenten der Vorrichtung. Alternativ oder zusätzlich kann die Fördereinrichtung 10 auch ein aktives Element sein, wie zum Beispiel eine Förderschnecke, ein Transportband, ein Gebläse oder ähnliches.

Der Reaktor 1 weist einen Einlass 7 auf, durch den die Kurzfasern in den Reaktor geführt werden. Der Reaktor 1 weist einen Innenraum (oder Hohlraum) auf, der mit einem Reaktionsgas gefüllt ist. Das Reaktionsgas kann auch durch den Reaktor 1 strömen (in Figur 1 zum Beispiel von links nach rechts).

Die Vorrichtung weist ferner einen Heizer 3 auf, der dazu eingerichtet ist, den Reaktor 1 zu heizen. Dabei wird ein in dem Reaktionsgas enthaltener Stoff aus dem Reaktionsgas abgeschieden und lagert sich auf den Kurzfasern ab. Mit anderen Worten findet eine chemische Gasphasenabscheidung des Stoffes aus dem Reaktionsgas und Ablagerung auf den Fasern statt.

Nach dem Durchlaufen der Reaktionszone des Reaktors 1, insbesondere dem Innenraum des Reaktors 1, verlassen die (nun beschichteten) Kurzfasern den Reaktor 1 über einen Auslass 8. An dem Auslass 8 kann ein passives Element 20 zum Abtransport der beschichteten Fasern angeschlossen sein, wie zum Beispiel ein Schlauch, eine Rutsche, ein Rohr oder ähnliches. Ebenfalls alternativ oder zusätzlich kann eine Fördereinrichtung in Form eines aktiven Elements vorgesehen sein, wie zum Beispiel eine Förderschnecke, ein Transportband, ein Gebläse, eine Vakuumpumpe oder ähnliches.

Auf jeden Fall werden die Kurzfasern nach Verlassen des Reaktors 1 in einem Auffangbehälter 25 gesammelt. Darin werden die fertigen und beschichteten Kurzfasern zur weiteren Verwendung und/oder Verarbeitung aufbewahrt.

Die Förderung der Kurzfasern durch den Reaktor 1 erfolgt über einen erregenden Antrieb 6, der dazu eingerichtet ist, den Reaktor in Schwingung zu versetzen. Hierbei wird eine niederfrequente Schwingung eingesetzt, die dafür sorgt, dass die Kurzfasern im Innenraum des Reaktors 1 hochgeworfen werden und somit im Innenraum (der Reaktionszone) des Reaktors 1 dispergieren. Dort können die Fasern sehr einheitlich auf allen Seiten von dem in dem Reaktionsgas enthaltenen Stoff umgeben und beschichtet werden. Die Schwingung kann beispielsweise eine Frequenz zwischen 1 Hz und 80 Hz, bevorzugt zwischen 10 Hz und 40 Hz, haben.

Der erregende Antrieb 6 kann in Form eines Kurbelwellenantriebs, wie er in Figur 1 gezeigt ist, in einfacher Form umgesetzt werden. Alternativ oder zusätzlich kann der erregende Antrieb 6 auch einen Nockenwellenantrieb, einen Piezoaktuator und/oder eine oder mehrere Federn umfassen.

Eine Kopplung zwischen dem Reaktor 1 und dem erregenden Antrieb 6 kann über ein Gestänge, ein Seil oder eine ähnliche Aufhängung oder Lagerung erfolgen, das/die in Figur 1 mit dem Bezugszeichen 5 gekennzeichnet ist. Die Vorrichtung kann eine Kopplung auch über eine Kippvorrichtung bewerkstelligen, die dazu eingerichtet ist, den Reaktor 1 zu kippen. Diese Neigung des Reaktors 1, die zwischen 0° und 10°, bevorzugt zwischen 0° und 5°, gegenüber einer Horizontalen betragen kann, ermöglicht eine Flugbahn der Kurzfasern in der Reaktionszone des Reaktors 1, die zum Auslass 8 des Reaktors 1 gerichtet ist. So kann beispielsweise das Ende des Reaktors 1 mit dem Auslass 8 tiefer angeordnet sein als dessen Einlass 7. Die Kippvorrichtung 5 kann so ausgestaltet sein, dass die Neigung des Reaktors 1 frei eingestellt werden kann.

Der erregende Antrieb 6 kann optional Gegengewichte (nicht dargestellt) aufweisen. Das dadurch erzielte Auswuchten verhindert oder zumindest minimiert eine Übertragung der Schwingung auf die gesamte Vorrichtung, sodass Maschinenschwingungen verringert werden.

Die Vorrichtung kann ferner einen Ofen 2 umfassen, der den Heizer 3 und zumindest Teile des Reaktors 1 umgibt und thermisch isoliert. Somit kann eine hohe und einheitliche Temperatur in der Reaktionszone des Reaktors 1 erzielt werden. Um eine kontinuierliche Zufuhr von Kurzfasern in den Reaktor 1 und/oder eine Entnahme beschichteter Kurzfasern aus dem Reaktor 1 zu ermöglichen, kann der Ofen 2 mindestens eine Öffnung 4 umfassen, durch die der Reaktor 1 in den bzw. aus dem Ofen 2 ragt.

Ferner kann die Vorrichtung ein Gehäuse 30 umfassen, das zumindest den Reaktor 1 umgibt. Wie in Figur 1 beispielhaft dargestellt, kann das Gehäuse 30 sämtliche Komponenten der Vorrichtung umfassen, mit der Ausnahme des Vorratsbehälters 15 und/oder des Auffangbehälters 25.

Reaktionsgas kann in den Reaktor 1 über eine Gaszufuhrleitung 50 (oder Gaszuleitung) eingeleitet werden. Entsprechend kann das Reaktionsgas nach dem Verlassen des Reaktors 1 über eine Gasabfuhrleitung 55 (Gasableitung) abgeführt werden. Zwischen Vorratsbehälter 15 und Reaktor 1 kann ein Einlassventil 40 vorgesehen sein, das den Vorratsbehälter 15 von dem Reaktor 1 (und auch der Gaszufuhrleitung 50) hermetisch verschließt. Ebenso kann auf der Auslassseite des Reaktors 1 ein Auslassventil 45 vorgesehen sein, das den Auffangbehälter 25 von dem Reaktor 1 (und auch der Gasabfuhrleitung 55) hermetisch verschließt. Dadurch kann im Betrieb (insbesondere bei laufendem Heizer 3 und erregendem Antrieb 6) der Vorratsbehälter 15 und/oder der Auffangbehälter 25 ausgewechselt werden. Der Gasstrom des Reaktionsgases von der Gaszufuhrleitung 50 durch den Reaktor 1 zu der Gasabfuhrleitung 55 kann dabei aufrechterhalten werden. Somit wird eine kontinuierliche oder semi-kontinuierliche Beschichtung von Kurzfasern ermöglicht.

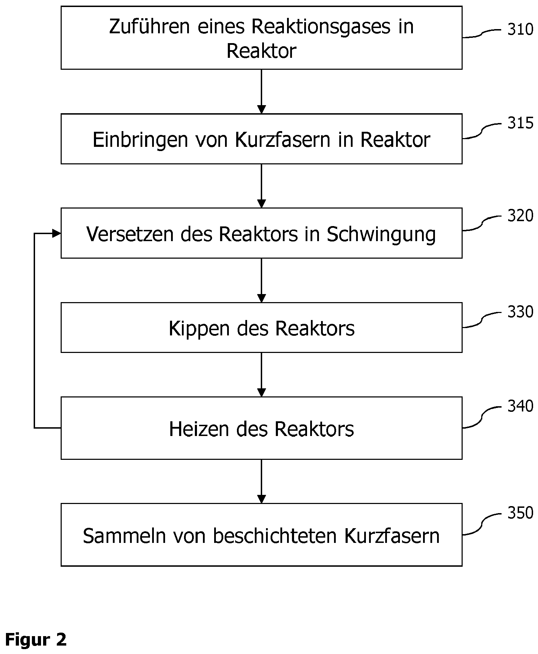

Figur 2 zeigt schematisch ein Ablaufdiagramm eines beispielhaften Verfahrens zur Beschichtung von Kurzfasern. Das Verfahren kann beispielsweise mithilfe einer Vorrichtung gemäß Figur 1 durchgeführt werden. Selbstverständlich können auch andere Vorrichtungen eingesetzt werden, um das Verfahren auszuführen.

In einem ersten Schritt 310 wird Reaktionsgas in den Reaktor 1 zugeführt. Das Reaktionsgas kann aus einem Behälter (nicht dargestellt) oder einer Fördereinrichtung oder anderen Quelle in den Reaktor 1 eingelassen werden, zum Beispiel über die Gaszufuhrleitung 50.

In einem weiteren Schritt 315 werden Kurzfasern in einen Reaktor 1 eingebracht. Dies kann über einfaches Einschütten oder anderweitiges Befüllen des Reaktors 1 mit Kurzfasern erreicht werden. Alternativ oder zusätzlich kann auch über eine Fördereinrichtung 10 oder Ähnliches eine kontinuierliche Zufuhr von Kurzfasern in den Reaktor 1 erfolgen.

Die Schritte 310 und 315 können selbstverständlich auch gleichzeitig ausgeführt werden. So kann auch ein Strom des Reaktionsgases in den Reaktor 1 hinein verwendet werden, um die Kurzfasern in den Reaktor 1 einzubringen, beispielsweise durch Einblasen der Kurzfasern mit dem Reaktionsgas.

Ein Versetzen des Reaktors 1 in eine Schwingung (Schritt 320) führt dazu, dass die Kurzfasern in dem Reaktor 1 aufgeworfen werden und in dem Reaktionsgas dispergieren. Beispielsweise kann der Reaktor 1 in eine Schwingung zwischen 1 Hz und 80 Hz, bevorzugt zwischen 10 Hz und 40 Hz, gebracht werden. Durch das "Aufwirbeln" der Kurzfasern in der Reaktionszone des Reaktors 1, und lediglich optional durch den Strom des Reaktionsgases durch den Reaktor 1 hindurch, werden die Kurzfasern innerhalb des Reaktors 1 weitertransportiert.

Dieses Transportieren der Kurzfasern kann unterstützt werden durch ein Kippen des Reaktors 1 in Schritt 330. Beispielsweise kann ein Auslass 8 (Ende) des Reaktors 1 tiefer liegen als ein Einlass 7 des Reaktors 1, sodass die Wurfbahn der Kurzfasern im Inneren des Reaktors 1 tendenziell zu dem Auslass 8 des Reaktors 1 führt. Dies erlaubt ferner einen sehr geringen oder gar keinen Strom von Reaktionsgas durch den Reaktor.

Die Schritte 320 (Schwingung) und 330 (Kippen) können miteinander kombiniert werden und zeitgleich erfolgen. Alternativ kann der Reaktor 1 erst gekippt werden und anschließend in Schwingung versetzt werden.

Ferner umfasst das Verfahren ein Heizen des Reaktors 1 in Schritt 340. Selbstverständlich kann das Verfahren auch mit dem Heizen (Schritt 340) des Reaktors 1 beginnen und die übrigen Schritte des Verfahrens können dann erst durchgeführt werden, wenn sich eine statische Temperaturverteilung in dem Reaktor eingestellt hat. Dabei kann der Reaktor 1, zum Beispiel von außen, beheizt werden, sodass ein in dem Reaktionsgas enthaltener Stoff aus dem Reaktionsgas abgeschieden wird und sich auf den Kurzfasern ablagert. Beispielsweise kann bei Temperaturen zwischen 700 °C und 1600 °C, bevorzugt zwischen 900 °C und 1400 °C, Kohlenstoff und/oder Bornitrid im pyrolytischen Zustand auf den Kurzfasern abgelagert werden, d. h. die Kurzfasern damit beschichtet werden.

Schließlich werden in einem optionalen Schritt 350 die beschichteten Kurzfasern gesammelt. Dies kann beispielsweise mithilfe eines Auffangbehälters 25 erfolgen, in den die beschichteten Kurzfasern nach Verlassen des Reaktors 1 fallen und gesammelt werden.

Die hier beschriebenen Parameter für das Verfahren und die Vorrichtung können selbstverständlich in den in den Figuren dargestellten beispielhaften Ausführungsformen Einsatz finden. Die hier beschriebenen Ausführungsformen sind lediglich beispielhaft und dienen nur der Erläuterung der vorliegenden Erfindung.

## Patentansprüche

1. Verfahren zum Beschichten von Kurzfasern, umfassend:
Zuführen (310) eines Reaktionsgases in einen Reaktor (1);
Einbringen (315) von Kurzfasern in den Reaktor (1);
Versetzen (320) des Reaktors (1) in eine Schwingung zwischen 1 Hz und 80 Hz, bevorzugt zwischen 10 Hz und 40 Hz;
Kippen (330) des Reaktors (1); und
Heizen (340) des Reaktors (1), wobei ein in dem Reaktionsgas enthaltener Stoff aus dem Reaktionsgas abgeschieden wird und sich auf den Kurzfasern ablagert.

2. Verfahren gemäß Anspruch 1, wobei das Versetzen (320) des Reaktors (1) in eine Schwingung ein Bewegen des Reaktors (1) mit einer Amplitude zwischen 0,5 mm und 10 mm, bevorzugt zwischen 1 mm und 5 mm, umfasst.

3. Verfahren gemäß Anspruch 1 oder 2, ferner umfassend:
Sammeln (350) der beschichteten Kurzfasern aus dem Reaktor (1) in einem Auffangbehälter (25).

4. Verfahren gemäß einem der Ansprüche 1 bis 3, wobei das Heizen (340) ein Heizen des Reaktors (1) auf eine Temperatur zwischen 700 °C und 1600 °C, bevorzugt auf eine Temperatur zwischen 900 °C und 1400 °C, umfasst.

5. Verfahren gemäß einem der Ansprüche 1 bis 4, wobei das Kippen (330) ein Kippen des Reaktors (1) auf eine Neigung von 0° bis 10°, bevorzugt auf eine Neigung von 0° bis 5°, gegenüber einer Horizontalen umfasst.

6. Verfahren gemäß einem der Ansprüche 1 bis 5, wobei die Kurzfasern Kohlenstofffasern und/oder Siliziumcarbidfasern sind, und/oder
wobei die Kurzfasern eine Faserlänge kleiner gleich 3 mm, bevorzugt kleiner gleich 1 mm, weiterhin bevorzugt eine Faserlänge von 5 bis 1000 µm, besonders bevorzugt zwischen 10 bis 500 µm, aufweisen, und/oder
wobei der abzuscheidende Stoff aus dem Reaktionsgas Kohlenstoff und/oder Bornitrid ist, und die Kurzfasern mit pyrolytischem Kohlenstoff und/oder pyrolytischem Bornitrid beschichtet werden.

7. Vorrichtung zum Beschichten von Kurzfasern, umfassend:
einen Reaktor (1);
eine Fördereinrichtung (10), die dazu eingerichtet ist, Kurzfasern in den Reaktor (1) einzubringen;
ein Mittel zum Zuführen eines Reaktionsgases in den Reaktor (1);
einen erregenden Antrieb (6), der dazu eingerichtet ist, den Reaktor (1) in eine Schwingung zwischen 1 Hz und 80 Hz, bevorzugt zwischen 10 Hz und 40 Hz, zu versetzen;
eine Kippvorrichtung (5), die dazu eingerichtet ist, den Reaktor (1) zu kippen;
einen Heizer (3), der dazu eingerichtet ist, den Reaktor (1) zu heizen, wobei ein in dem Reaktionsgas enthaltener Stoff aus dem Reaktionsgas abgeschieden wird und sich auf den Kurzfasern ablagert.

8. Vorrichtung gemäß Anspruch 7, ferner umfassend:
einen Vorratsbehälter (15), in dem unbeschichtete Kurzfasern für die Förderung durch die Fördereinrichtung (10) gelagert werden; und/oder
einen Auffangbehälter (25), der dazu eingerichtet ist, beschichtete Fasern aus dem Reaktor (1) zu sammeln.

9. Vorrichtung gemäß Anspruch 8, ferner umfassend:
ein Einlassventil (40), das dazu eingerichtet ist, den Vorratsbehälter (15) von dem Reaktor (1) hermetisch zu verschließen; und/oder
ein Auslassventil (45), das dazu eingerichtet ist, den Auffangbehälter (25) von dem Reaktor (1) hermetisch zu verschließen.

10. Vorrichtung gemäß einem der Ansprüche 7 bis 9, wobei der erregende Antrieb (6) einen Kurbelwellenantrieb, einen Piezoaktuator, eine oder mehrere Federn und/oder einen Nockenwellenantrieb umfasst.

11. Vorrichtung gemäß einem der Ansprüche 7 bis 10, ferner umfassend:
einen Ofen (2), der den Heizer (3) und zumindest Teile des Reaktors (1) umgibt und thermisch isoliert,
wobei der Ofen (2) mindestens eine Öffnung (4) umfasst, durch die der Reaktor (1) in den Ofen (2) ragt.

12. Vorrichtung gemäß einem der Ansprüche 7 bis 11, wobei die Kippvorrichtung (5) den Reaktor (1) in einer einstellbaren Neigung lagert, und/oder
wobei die Kippvorrichtung (5) mit dem erregenden Antrieb (6) gekoppelt ist und die Schwingung des erregenden Antriebs (6) auf den Reaktor (1) überträgt.

13. Vorrichtung gemäß einem der Ansprüche 7 bis 12, ferner umfassend:
eine Gaszufuhrleitung (50), die dazu eingerichtet ist, das Reaktionsgas zu der Fördereinrichtung (10) und/oder zu dem Reaktor (1) zu führen; und/oder
eine Gasabfuhrleitung (55), die dazu eingerichtet ist, dass Reaktionsgas nach Verlassen des Reaktors (1) abzuführen.

14. Vorrichtung gemäß einem der Ansprüche 7 bis 13, ferner umfassend:
ein Gehäuse (30), das den Reaktor (1) umgibt,
wobei vorzugsweise das Gehäuse (30) den Heizer (3) und/oder den erregenden Antrieb (6) und/oder die Kippvorrichtung (5) umgibt.
